(19) Europäisches Patentamt

European Patent Office

Office européen des brevets

(11) **EP 1 720 069 A2**

(12) **EUROPEAN PATENT APPLICATION**

(43) Date of publication:
08.11.2006 Bulletin 2006/45

(51) Int Cl.:
*G03F 7/20* (2006.01)

(21) Application number: 06005417.8

(22) Date of filing: 16.03.2006

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: 07.04.2005 US 669464 P

(71) Applicant: **Carl Zeiss SMT AG**
**73446 Oberkochen (DE)**

(72) Inventors:
• **Epple, Alexander, Dr.**
**73431 Aalen (DE)**
• **Stickel, Franz-Josef, Dr.**
**73447 Oberkochen (DE)**

(74) Representative: **Schorr, Frank Jürgen et al**
**Diehl & Partner,**
**Augustenstrasse 46**
**80333 München (DE)**

(54) **Method of manufacturing a projection-optical system**

(57)   A method of manufacture of a projection-optical system involves generating a new design thereof starting from an existing previous design. Herein, a combined design is subject to optimization, wherein the combined design comprises the design of the projection-optical system and a design of an interferometer optics used for measuring an aspherical surface of a lens of the projection-optical system.

Fig. 5

**Description**

**Background of the Invention**

**Field of the Invention**

The present invention relates to manufacturing a projection-optical system which may be used in a lithographic process of manufacturing miniaturized devices.

**Brief Description of Related Art**

Lithographic processes are commonly used in the manufacture of miniaturized devices, such as integrated circuits, liquid crystal elements, micro-patterned structures and micro-mechanical components.

A projection-exposure apparatus used for photolithography generally comprises a projection-optical system for imaging a patterning structure, commonly referred to as a reticle, onto a substrate, commonly referred to as a wafer. The substrate (wafer) is coated with a photosensitive layer, commonly referred to as a resist, which is exposed with an image of the patterning structure using imaging light.

The trend to produce even smaller and more sophisticated miniaturized devices places increasingly high demands on the projection-optical system. The conventional projection-optical system is a sophisticated apparatus comprising a plurality of lenses, such as twenty-five or even more lenses, which are designed and manufactured to a high accuracy to provide an imaging of the patterning structure onto the substrate within a large field and with low image distortions. The manufacture of the lenses to the high required accuracy also includes measuring of a surface shape of a surface of each lens using an interferometer apparatus, determining differences between the measured surface shape and a target shape determined by a design of the projection-optical system, and processing the surface based on the determined differences. Current projection-optical systems typically comprise a number of aspherical lenses having at least one surface of an aspherical shape, and with increasing demands on the optical performance of the projection-optical system, the number of aspherical lenses in the projection-optical system is expected to increase. An interferometer apparatus for measuring an aspherical surface comprises an interferometer optics which is also referred to as a compensating system or null-lens arrangement generating measuring light incident on the aspherical surface under test such that the measuring light is orthogonally incident on the surface under test at each location thereof. In other words, the interferometer optics has to generate the measuring light such that wavefronts thereof have aspherical shapes corresponding to the aspherical shape under test. It appears that a separate interferometer optics has to be provided for testing of each aspherical surface comprised in the projection-optical system to be manufactured.

Thus, manufacturing of a projection-optical system according to a new design requires manufacturing of plural new interferometer optics to be able to test the surfaces of the lenses of the projection-optical system according to the new design. It appears that a change in the optical design of the projection-optical system is cost-intensive already due to the fact that additional interferometer optics have to be provided for testing.

Further, generating a new design of the projection-optical system is a complicated task involving an optimization of parameters of the projection-optical system. The parameters include refractive indices of materials of which the lenses are formed, surface shape parameters of the lenses, distances between first and second surfaces of each lens, distances between surfaces of different lenses, a distance between the object plane of the projection-optical system and a surface of an object-side front lens of the projection-optical system, a distance between the image plane and an image-side front lens of the projection-optical system, and refractive indices of media disposed between adjacent lenses, between the object plane and the object-side front lens and between the image plane and the image-side front lens. It appears that a design of a projection-optical system having such as thirty lenses comprises many parameters, wherein boundary conditions such as a minimum distance between adjacent lenses have to be fulfilled.

An optimization of the design to conform to a desired specification of the optical performance of the projection-optical system involves computational methods such as ray tracing and optimizing the parameters of the system while observing the boundary conditions. The optimization includes minimizing or maximizing a suitably chosen merit function depending on the parameters of the design. Due to the high number of parameters of the design, the space of the solutions of the optimization has a high dimension, and there are many local minima and maxima in this space of solutions such that computational methods tend to converge or get trapped in local minima and maxima, respectively, which are far away from designs fulfilling a particular optical performance.

Thus, a designer of the projection-optical system has a sophisticated task to determine principals of a new design based on his intuition. The designer will then suggest a new configuration of the projection-optical system and improve the design thereof by computational optimization. Typically a result of such optimized suggested new configuration is insufficient with respect to an optical performance of the optimized design, and the designer will have to suggest and try many configurations until a satisfactory solution is found.

Thereafter, interferometer optics associated with each of the aspherical lenses have to be designed, and often it turns out that an interferometer optics suitable for testing a particular aspherical lens of an otherwise satisfactory design may not be constructed, and the designer will also have to take testability of the aspherical lenses into account when designing a new projection-optical system.

It appears that the design and manufacture of new projection-optical systems is laborious and troublesome.

## Summary of the Invention

The present invention has been accomplished taking the above problems into consideration.

Embodiments of the present invention provide an improved method of manufacturing a projection-optical system.

In particular, embodiments of the present invention provide a method of manufacturing a projection-optical system according to a new design.

Further embodiments of the present invention provide a method of manufacturing a projection-optical system having at least one aspherical surface which may be measured with reduced efforts.

According to an exemplary embodiment of the present invention a method of manufacturing a projection-optical system according to an optimized design is provided. Herein parameters of both the projection-optical system and of an interferomter optics used for measuring at least one aspherical lens surface of the projection-optical system are optimized in a common optimization process. Thus, the design of the projection-optical system is closely linked with the design of the interferometer optics associated therewith. They are both subject to a common optimization rather than independent from each other as usual in the art.

Within the context of the present application, an optical surface may be referred to as an aspherical surface if the aspherical surface differs from its best approximating sphere by more than a predetermined criterion. One such criterion is based on a gradient of the difference between the aspherical surface and its best approximating sphere, and the optical surface is referred to as an aspherical surface if such gradient exceeds a value of 6 $\mu$m divided by an effective diameter of the optical surface.

According to an embodiment of the invention, the optimization of free parameters of the design of the projection-optical system and at least one free parameter of the design of the interferometer optics is based on a merit function which is at least dependent on values of fixed parameters of the design of the projection-optical system, on values of the free parameters of the projection-optical system, on values of fixed parameters of the interferometer optics and on a value of the at least free parameter of the interferometer optics.

According to an embodiment of the invention, the at least one free parameter of the design of the interferometer optics represents a distance between a pair of adjacent lenses of the interferomter optics. According to an embodiment herein, all distances between pairs of adjacent lenses of the interferometer optics are free parameters.

According to a further embodiment, shape parameters of and a distance between the two surfaces of at least one lens of the interferometer optics are fixed parameters of the design thereof. According to particular embodiments, two or more lenses of the projection-optical system have shape and distance parameters which are fixed. This allows for re-use of existing components of previously manufactured interferometer optics. In particular, a previous design of the previously manufactured interferometer optics may be modified by adjusting distances between adjacent lenses while maintaining the lenses themselves, which are the most expensive components of the interferomter optics since they have to be manufactured to a high accuracy.

According to an embodiment of the invention, the design of a new projection-optical system starts from a previous design, wherein at least one value of a parameter of the previous design is modified and used as a fixed parameter in the optimization of the new design. It is then possible to manufacture the projection-optical system according to the new design while re-using main components of the interferometer optics for testing aspherical lenses of the projection-optical system according to the previous design.

In particular, this allows to manufacture the projection-optical system according to a new design differing from the previous design of the previously manufactured projection-optical system with respect to parameters such as a material of a particular lens and a medium disposed in a space between adjacent lenses or in a space between the image plane and the image-side front lens of the system. For example, a previous design having a gaseous medium in the space between the image plane and the image-side front lens may be easily modified to have a liquid disposed in that space.

The above illustrated method provides a pair of projection optical systems, wherein a first projection-optical system of said pair is manufactured according to the previous design and wherein a second projection-optical system of said pair is manufactured according to the new design differing from the previous design in view of those parameters which were subject to the optimization. More generally, the invention provides a pair of projection-optical systems wherein a first projection-optical system of said pair has a first design and wherein a second projection-optical system of said pair has a second design differing from the first design in various properties as illustrated in more detail below. With such pair of projection-optical systems according to two different designs it is possible to offer two different types of projection-optical systems to customers while sharing components and manufacturing resources between the projection-optical systems according to the different designs.

According to an exemplary embodiment under this aspect, the invention provides a pair of projection-optical systems, wherein each of the plurality of optical elements has at least one optical surface, and wherein at least one optical surface of at least one of the plurality of optical elements is an aspherical surface; wherein a first projection optical system of the pair of projection optical systems has a first group of optical elements, wherein each lens of the first group of lenses of the first projection optical system is defined by surface parameters of first and second surfaces and a distance between the first and second surfaces; wherein a second projection optical system of the pair of projection optical systems has a second group of lenses, wherein each lens of the second group has associated therewith a corresponding lens of the first group such that each pair of corresponding lenses of the first and second groups have substantially identical surface parameters of their first and second surfaces and substantially identical distances between their first and second surfaces; wherein a surface shape of the aspherical surface of the first projection optical system may be tested by using an interferometer apparatus having a first interferometer optics and wherein a surface shape of the aspherical surface of the second projection optical system is different from the surface shape of the aspherical surface of the first projection optical system and may be tested by an interferometer apparatus having a second interferometer optics; wherein the first interferometer optics has a third group of lenses, wherein each lens of the third group of lenses of the first interferometer optics is defined by surface parameters of first and second surfaces and a distance between the first and second surfaces of the lens; wherein the second interferometer optics has a fourth group of lenses, wherein each lens of the fourth group has associated therewith a corresponding lens of the third group such that each pair of corresponding lenses of the third and fourth groups have substantially identical surface parameters of their first and second surfaces and substantially identical distances between their first and second surfaces; wherein at least one distance between a pair of adjacent lenses of the third group of lenses differs from a distance between a corresponding pair of adjacent lenses of the fourth group of lenses by more than 0.1 mm, or wherein a distance between the aspherical surface of the first projection optical system and a lens of the first interferometer optics closest to the aspherical surface in a testing position thereof differs from a distance between the aspherical surface of the second projection optical system and a lens of the second interferometer optics closest to the aspherical surface in a testing position thereof by more than 0.1 mm.

**Brief Description of the Drawings**

The forgoing as well as other advantageous features of the invention will be more apparent from the following detailed description of exemplary embodiments of the invention with reference to the accompanying drawings. It is noted that not all possible embodiments of the present invention necessarily exhibit each and every, or any, of the advantages identified herein.

Figure 1     is a schematic illustration of a projection-optical system according to a previous design;

Figure 2     is a schematic illustration of an interferometer apparatus for measuring an aspherical surface of a lens of the projection-optical system shown in Figure 1;

Figure 3     is an illustration of a method of manufacture of a projection-optical system of a new design according to an embodiment of the invention;

Figure 4     is a schematic illustration of a projection-optical system according to the new design; and

Figure 5     is a schematic illustration of an interferometer apparatus for measuring an aspherical surface of a lens of the projection-optical system shown in Figure 4.

**Detailed Description of Exemplary Embodiments**

In the exemplary embodiments described below, components that are similar in function and structure are designated as far as possible by similar reference numerals. Therefore, to understand the features of the individual components of a specific embodiment, the descriptions of other embodiments and of the summary of the invention should be referred to.

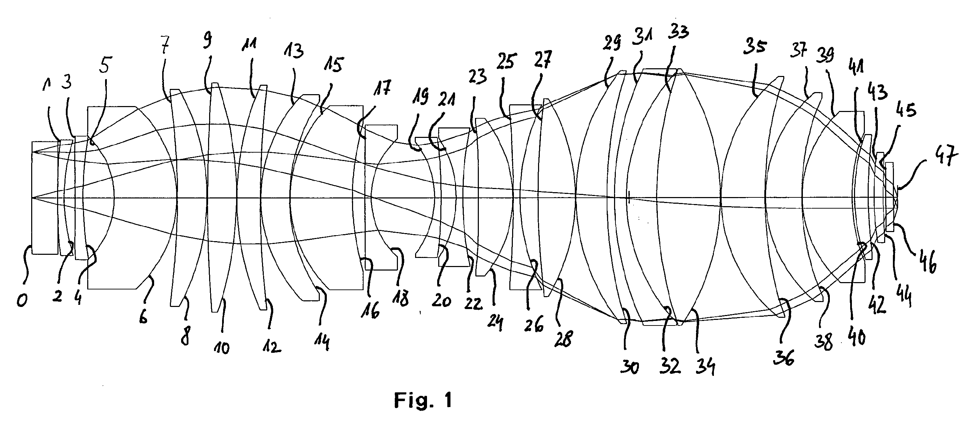

Figure 1 illustrates a projection-optical system 100 according to a previous design disclosed in co-pending patent application with serial no. 60/526,096 of the applicants, which document is incorporated herein by reference. The previous design was developed by its designers based on their intuition and support by mathematical methods involving ray tracing and optimization of parameters of the design.

Detailed information on parameters of the design, such as lens materials, distances between lens surfaces, radius of curvature of the lens surfaces and diameters of the lens surfaces are given in Table 1 below.

**Table 1**

| Surface | Radius | Thickness | Material | Index | Semidiam. |
|---|---|---|---|---|---|
| 0 | object plane | 32.0000 | AIR | 1.000302 | 56.1 |
| 1 | 57573.3843 | 8.0000 | SIO2V | 1.560786 | 64.5 |
| 2 | 243.8108 | 13.2623 | N2 | 1.000300 | 66.1 |
| 3 | -1090.1430 | 9.3540 | SIO2V | 1.560786 | 67.4 |
| 4 | 466.1455 | 37.4850 | N2 | 1.000300 | 70.6 |
| 5 | -105.4891 | 75.0000 | SIO2V | 1.560786 | 72.2 |
| 6 | -148.9142 | 0.7001 | N2 | 1.000300 | 107.4 |
| 7 | -934.5665 | 36.2435 | SIO2V | 1.560786 | 123.6 |
| 8 | -274.0353 | 0.7000 | N2 | 1.000300 | 127.3 |
| 9 | 1877.0035 | 35.1457 | SIO2V | 1.560786 | 133.6 |
| 10 | -433.1584 | 0.7000 | N2 | 1.000300 | 134.4 |
| 11 | 340.4737 | 28.3403 | SIO2V | 1.560786 | 131.8 |
| 12 | 1177.9580 | 0.7000 | N2 | 1.000300 | 130.2 |
| 13 | 180.5848 | 34.5615 | SIO2V | 1.560786 | 121.3 |
| 14 | 206.7582 | 0.7000 | N2 | 1.000300 | 112.2 |
| 15 | 155.9390 | 75.0000 | SIO2V | 1.560786 | 108.4 |
| 16 | 281.7713 | 15.0267 | N2 | 1.000300 | 85.6 |
| 17 | 15953.6157 | 8.0000 | SIO2V | 1.560786 | 83.1 |
| 18 | 98.4316 | 77.0680 | N2 | 1.000300 | 68.6 |
| 19 | -111.3081 | 8.0193 | SIO2V | 1.560786 | 64.3 |
| 20 | -702.5092 | 18.0306 | N2 | 1.000300 | 68.1 |
| 21 | -138.0765 | 8.3622 | SIO2V | 1.560786 | 68.7 |
| 22 | 416.9722 | 18.6943 | N2 | 1.000300 | 79.1 |
| 23 | -11234.1701 | 41.8736 | SIO2V | 1.560786 | 85.2 |
| 24 | -150.8930 | 0.7000 | N2 | 1.000300 | 91.4 |
| 25 | -1297.1009 | 8.0000 | SIO2V | 1.560786 | 99.9 |
| 26 | 253.3111 | 21.7358 | N2 | 1.000300 | 107.8 |
| 27 | 1068.9167 | 45.0713 | SIO2V | 1.560786 | 111.5 |
| 28 | -236.4449 | 0.7000 | N2 | 1.000300 | 115.7 |
| 29 | 244.0241 | 37.6564 | SIO2V | 1.560786 | 149.3 |
| 30 | 555.3749 | 9.1292 | N2 | 1.000300 | 148.6 |
| 31 | 360.5437 | 15.0000 | SIO2V | 1.560786 | 151.1 |
| 32 | 221.8805 | 36.4723 | N2 | 1.000300 | 148.0 |
| 33 | 488.3008 | 77.1255 | SIO2V | 1.560786 | 149.9 |
| 34 | -279.9149 | 0.7000 | N2 | 1.000300 | 151.5 |

(continued)

| Surface | Radius | Thickness | Material | Index | Semidiam. |
|---|---|---|---|---|---|
| 35 | 187.8756 | 53.2248 | SIO2V | 1.560786 | 142.9 |
| 36 | 489.3066 | 0.7002 | N2 | 1.000300 | 139.2 |
| 37 | 163.2750 | 44.1943 | SIO2V | 1.560786 | 123.4 |
| 38 | 325.3976 | 0.7000 | N2 | 1.000300 | 116.2 |
| 39 | 140.8663 | 60.7172 | SIO2V | 1.560786 | 100.5 |
| 40 | 235.7238 | 2.9966 | N2 | 1.000300 | 73.2 |
| 41 | 232.8150 | 16.6707 | SIO2V | 1.560786 | 71.3 |
| 42 | 582.7767 | 6.7716 | N2 | 1.000300 | 63.9 |
| 43 | 375.4083 | 11.2935 | SIO2V | 1.560786 | 50.0 |
| 44 | 687.6552 | 3.0985 | N2 | 1.000300 | 42.2 |
| 45 | 0.0000 | 9.3750 | SIO2V | 1.560786 | 36.7 |
| 46 | 0.0000 | 5.0000 | AIR | 1.000302 | 29.5 |
| 47 | image plane | | | | |

Ten lenses have one aspherical surface, and surface parameters of the aspherical surfaces may be represented by the following conventional notation:

$$p(h) = \frac{\dfrac{h^2}{r}}{1 + \sqrt{1 - (1+K)\dfrac{h^2}{r^2}}} + C1 \cdot h^4 + C2 \cdot h^6 + \dots \qquad (1)$$

wherein

$r$       is radius of curvature in the apex of the aspherical surface (paraxial curvature),

$h$       is distance of a point on the aspherical surface from the optical axis (or height of the aspherical surface from the optical axis),

$p(h)$       is the sag of the surface in axial direction, i.e. a distance along the direction of the optical axis from a tangent plane to a vertex of the aspheric surface,

$K$       is a conical coefficient and

$C1 \dots C6$       are aspherical coefficients.

The surface parameters are listed in Table 2 below.

**Table 2**

| | Aspherical Surfaces | | | | |
|---|---|---|---|---|---|
| SRF | 1 | 3 | 7 | 16 | 20 |
| K | 0 | 0 | 0 | 0 | 0 |
| C1 | 2.187157E-07 | 2.909419E-08 | -1.506913E-09 | -3.774747E-08 | -1.136180E-09 |

(continued)

| Aspherical Surfaces | | | | | |
|---|---|---|---|---|---|
| C2 | -2.487757E-11 | 1.261210E-11 | 2.120740E-13 | 1.140271E-12 | -3.091171E-12 |
| C3 | 1.853585E-15 | -1.055565E-15 | 5.182820E-18 | 2.928811E-17 | -5.711004E-16 |
| C4 | -1.617589E-19 | 3.623046E-20 | 2.163295E-23 | -5.477432E-21 | 2.509741E-20 |
| C5 | 1.923071E-24 | 8.424309E-24 | -5.163241E-27 | 1.585045E-25 | 2.710175E-24 |
| C6 | 5.473790E-29 | -4.162924E-28 | 3.339083E-32 | 7.346294E-30 | -2.322363E-28 |
| | | | | | |
| SRF | 23 | 30 | 36 | 38 | 40 |
| K | 0 | 0 | 0 | 0 | 0 |
| C1 | -6.268577E-08 | 4.593566E-09 | 6.674974E-10 | 1.843071E-09 | 1.319594E-08 |
| C2 | 3.193567E-12 | -5.053471E-14 | 2.315644E-13 | 4.289011E-13 | 5.402084E-12 |
| C3 | -1.596579E-16 | 2.101535E-18 | -6.968850E-18 | 1.594513E-17 | -1.867305E-16 |
| C4 | 9.929517E-21 | -3.600921E-23 | 1.939934E-22 | -1.418581E-21 | -2.952249E-22 |
| C5 | -4.198491E-25 | 5.121271E-28 | 4.518881E-28 | 3.966239E-26 | 1.127199E-24 |
| C6 | 1.525257E-29 | -6.698801E-33 | -1.675385E-32 | -2.085351E-31 | -1.348324E-28 |

The projection-optical system shown in Figure 1 provides an image-side numerical aperture NA of 0.95 and a high imaging quality exemplified by a wavefront aberration of about 3.5 m$\lambda$.

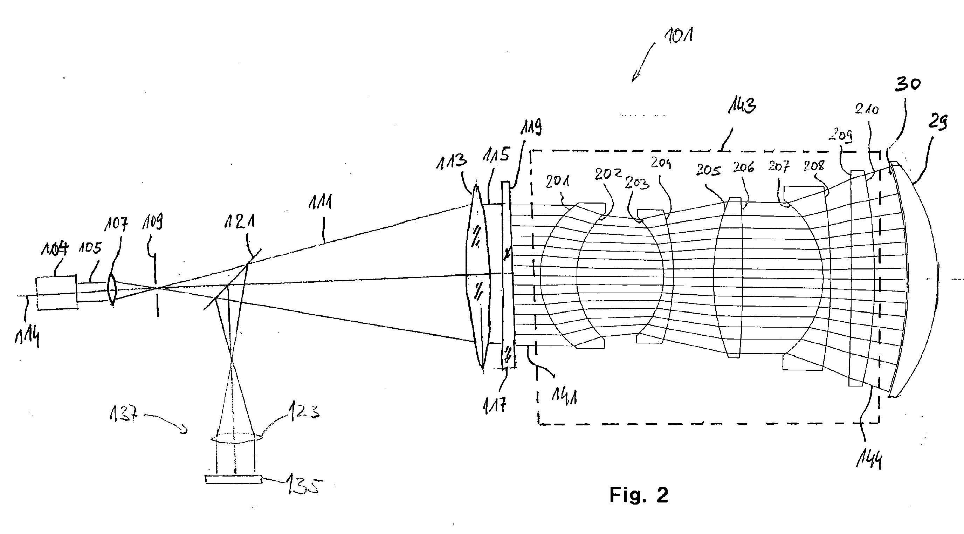

Figure 2 illustrates an interferometer apparatus 101 for testing aspherical surface number 30 of the projection-optical system 100 according to the previous design shown in Figure 1. The interferomter apparatus 101 comprises a light source 104, such as a helium-neon-laser, generating a laser light beam 105. Laser light beam 105 is focused by a focusing lens 7 onto a pinhole of a spatial filter 9 such that a divergent beam 111 of coherent measuring light is emitted from the pinhole. Wavefronts in the diverging beam 111 have a substantially spherical shape. The diverging beam 111 is collimated by one or more lenses 113 to form a parallel beam 115 having wavefronts of a substantially flat shape. Beam 115 traverses a substantially wedge-shaped plate 117 having a flat surface 119 which is oriented orthogonally to the direction of beam 115. Surface 119 forms a Fizeau surface of the interferometer apparatus 101 such that a portion of the beam 115 is retro-reflected from Fizeau surface 119 as a reference light, traverses lens 113 to be a converging beam reflected from a beam splitter 121 such that it is incident on a light sensitive substrate 135 of a camera 137 after traversing an objective lens 123.

A portion 141 of beam 115 traversing Fizeau surface 119 enters an interferometer optics 143 and is shaped by interferometer optics 143 such that a beam 144 of measuring light emitted from interferometer optics 143 is orthogonally incident on surface 30 at each location thereof. This means that the wavefronts of beam 144 have a shape which corresponds to the shape of the aspherical surface 30 at the position of surface 30. A portion of beam 144 is retro-reflected from surface 30, enters the interferometer optics 143 and is formed by interferomter optics 143 such that the beam leaving the interferometer optics has substantially flat wavefronts, traverses Fizeau surface 119 and is directed onto the substrate of camera 135 by collimating lens 113 and the beam splitter 121.

An interference pattern is generated on the light sensitive substrate 135 by a coherent superposition of the reference light reflected from Fizeau surface 119 and the measuring light reflected from surface 30 of the aspherical shape. An analysis of the generated interference pattern allows to determine surface deviations of the aspherical surface 30 from its target shape. The interferometer optics 143 may also be referred to as a null-lens arrangement or compensating system. Background information relating to interferometer optics for testing aspherical surfaces and interferogram evaluation may be obtained from Chapters 12 and 13 of the textbook of Daniel Malacara "Optical Shop Testing", 2nd Edition, John Wiley & Sons, Inc. 1992.

The interferometer optics 143 has the function of transforming the flat wavefronts of beam 141 into the aspherical wavefronts of beam 144 such that the aspherical wavefronts have substantially a same shape as the target shape of lens 30. For this purpose, the interferometer optics 143 comprises five lenses with surfaces 201 to 210, and optical data of the interferometer optics 143 are indicated in Table 3 below.

**Table 3**

| Surface | Radius | Thickness | Material | Index | Semidiam. |
|---------|--------|-----------|----------|-------|-----------|
| 201 | 118.4424 | 49.5864 | SIO2 | 1.457036 | 94.0 |
| 202 | 113.0460 | 118.5167 | | | 81.0 |
| 203 | -104.8578 | 13.2595 | SIO2 | 1.457036 | 76.0 |
| 204 | -276.5920 | 54.4991 | | | 84.0 |
| 205 | 278.2747 | 39.6057 | SIO2 | 1.457036 | 101.0 |
| 206 | -1557.8909 | 109.4869 | | | 102.0 |
| 207 | -126.6175 | 10.0000 | SIO2 | 1.457036 | 101.0 |
| 208 | -762.1531 | 28.6825 | | | 118.0 |
| 209 | -3832.9507 | 31.7486 | SIO2 | 1.457036 | 133.0 |
| 210 | -662.0750 | 43.4811 | | | 139.0 |
| 30 | -555.3749 | -43.4811 | REFL | | 151.0 |

Starting from the previous design of the projection-optical system illustrated in Figure 1 and Tables 1 and 2, it is assumed that a design task is defined to generate a modified design of an optical system which has a liquid medium disposed in a space between the object plane 47 and the front surface 46 of the projection-optical system.

With such immersion liquid, an achievable depth of focus of the imaging is increased as compared to the corresponding system having a gaseous medium disposed in this space. Background information relating to the projection-optical system of the immersion type is disclosed in WO 2003/077037 A1 and US 2004/0165159 A1, which documents are incorporated herein by reference.

According to the assumed design task, the modification of the previous design should be performed such that major characteristics of the imaging quality are not severely degraded, and such that interferometer optics 101 used for testing the aspherical surfaces of the lenses according to the previous design may be re-used as far as possible.

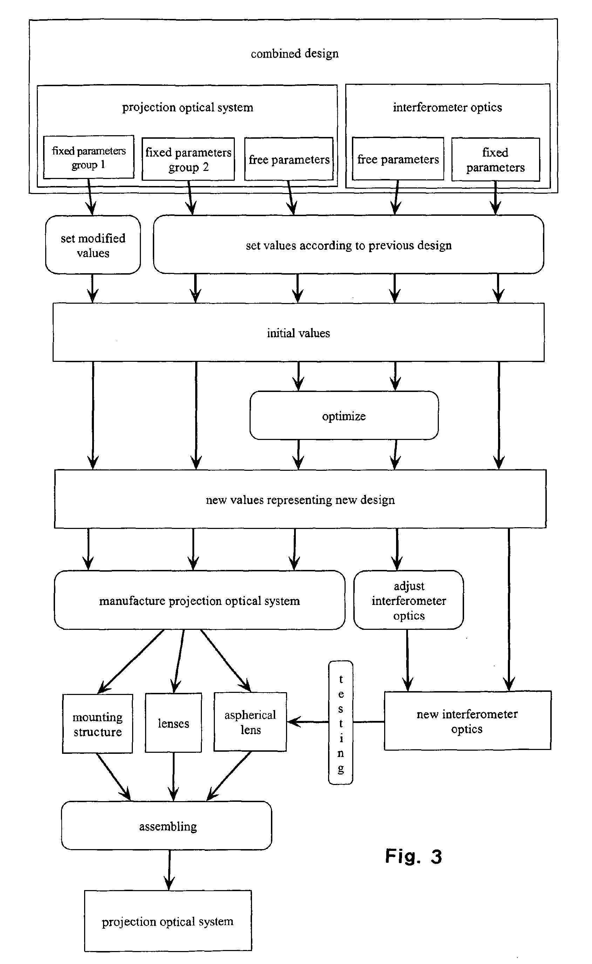

A method of generating such modified design is illustrated with reference to Figure 3 herein below.

A design of the projection-optical system 100 and the interferometer optics 101 is a combined design which is subject to a common optimization. The combined design comprises free parameters and fixed parameters. Values of the fixed parameters are maintained constant during optimization while values of the free parameters are changed such that an optimization result is improved.

The fixed parameters of the design of the projection-optical system are divided into two groups: Group 1 and Group 2. The fixed parameters of Group 1 are those parameters of the design of the projection-optical system which are modified by the definition of the design task as compared to the previous design. In the present example, a fixed parameter of Group 1 is the refractive index of the medium disposed in the space between the image plane 47 and the image-side back lens surface 46 of the projection-optical system. In the previous design according to Tables 1 and 2 the medium in the space is Air having a refractive index n = 1.000302. According to the design task, the medium disposed in that space of the new design is the immersion liquid, which is purified water having a refractive index n = 1.436677. Thus, the value of the parameter of the combined design representing the refractive index of the medium disposed in the space between the object plane 47 and the object-side front lens surface 46 is set to the modified value 1.436677 as compared to the corresponding value of the previous design.

The free parameters of the design of the projection-optical system comprise those parameters which represent distances between adjacent lenses in Table 1 above. Further, the free parameters of the projection-optical system comprise the surface parameters of surface 30 which is an aspherical surface. These parameters are indicated as parameters C1 through C6 in Table 2 above. Further, the free parameters of the design of the projection-optical system comprise the surface parameter of surface number 29 which is a spherical surface such that the surface parameter is a single parameter represented by the radius of surface 29. A further free parameter of the design of the projection-optical system is the thickness of the lens having surfaces 29 and 30, and a thickness of the lens having surfaces 45 and 46.

All other parameters of the design of the projection-optical system contained in Tables 1 and 2 are belong to fixed parameter Group 2. In particular the surface parameters of all lenses other than the surface parameters of surfaces 29, 30, 45 and 46 are fixed parameters and all thicknesses of lenses other than the lens having surfaces 29, 30, 45 and 46 are fixed parameters of the design of the projection-optical system.

Thus, the projection-optical system manufactured according to the new design will have mostly the same lenses as the projection-optical system according to the previous design, and only one lens of the projection-optical system of the new design will have to be manufactured differently than the corresponding lens of the projection-optical system according to the previous design.

The free parameters of the design of the interferometer optics comprise distances between adjacent lenses of the interferomter optics. The fixed parameters of the design of the interferometer optics comprise all other parameters of the design of the interferometer optics and in particular the surface shape parameters of surfaces 201 to 210, and the thicknesses of the corresponding lenses. Thus, the interferometer optics for measuring surface number 30 of the projection-optical system 100 according to the new design will correspond to the interferometer optics 101 for measuring surface 30 of the projection-optical system according to the previous design in that it comprises the same lenses disposed at adjusted distances from each other.

The initial values of the parameters of the combined design are set as follows: The values of the fixed parameters of Group 2 of the design of the projection-optical system are set equal to the values of the corresponding parameters of the previous design, and also the values of the free parameters of the projection-optical system are set equal to the values of the corresponding parameters of the projection-optical system according to the previous design. The values of both the free parameters and the fixed parameters of the design of the interferometer optics are set equal to the values of the corresponding parameters of the interferometer optics according to the previous design. Thus, most of the initial values of parameters are set equal to the corresponding values of the previous design. The only exception are the fixed parameters of Group 1, which are those parameters which are intentionally modified relative to the previous design according to the design task.

Having set the initial values, the design is subjected to an optimization to modify the free parameters of the combined design with an intention to optimize a suitably defined merit function. The merit function depends on the values of all parameters of the combined design, i.e. the fixed parameters of Group 1, the fixed parameters of Group 2, the free parameters of the design of the projection-optical system and the free parameters and fixed parameters of the design of the interferometer optics. The merit function may represent an imaging quality of the projection-optical system. Computational methods such as ray tracing and optimization algorithms are available to the skilled person to perform the necessary optimization steps. A result of the optimization is a set of values of the parameters of the combined design representing the new design of the projection-optical system.

Thereafter, the projection-optical system according to the new design may be manufactured, wherein all lenses of the projection-optical system of the previous design other than the lenses having surfaces 29, 30, and 45, 46 may be identically used. Only the lenses having surfaces 29, 30 and 45, 46 have to be manufactured according to a different process. Moreover, since the distances between adjacent lenses of the projection-optical system are comprised in the free parameters of the design, suitable mounting structures for mounting the lenses of the projection-optical system have to be manufactured differently from the manufacture of the projection-optical system according to the previous design.

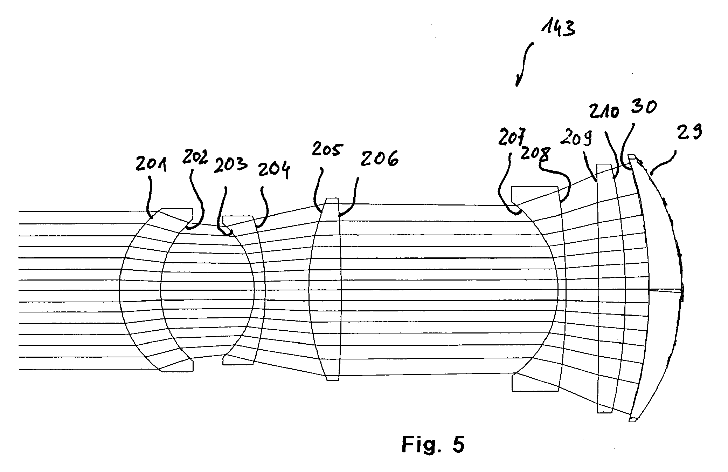

The interferometer optics for measuring surface 30 of the projection-optical system is obtained by re-arranging distances between the lenses of the interferometer optics while re-using the lenses thereof. The interferometer optics according to the new design is shown in Figure 5, and the optical data of the interferometer optics according to the new design are indicated in Table 4 below.

**Table 4**

| Surface | Radius | Thickness | Material | Index | Semidiam. |
|---------|-----------|-----------|----------|----------|-----------|
| 201 | 118.4424 | 49.5864 | SIO2 | 1.457036 | 95.0 |
| 202 | 113.0460 | 112.4933 | | | 82.0 |
| 203 | -104.8578 | 13.2595 | SIO2 | 1.457036 | 77.0 |
| 204 | -276.5920 | 51.8422 | | | 85.0 |
| 205 | 278.2747 | 39.6057 | SIO2 | 1.457036 | 103.0 |
| 206 | -1557.8909 | 260.0080 | | | 104.0 |
| 207 | -126.6175 | 10.0000 | SIO2 | 1.457036 | 101.0 |
| 208 | -762.1531 | 40.0040 | | | 118.0 |
| 209 | -3832.9507 | 31.7486 | SIO2 | 1.457036 | 138.0 |
| 210 | -662.0750 | 28.3831 | | | 144.0 |
| 211 | -557.4597 | -28.3831 | REFL | | 151.0 |

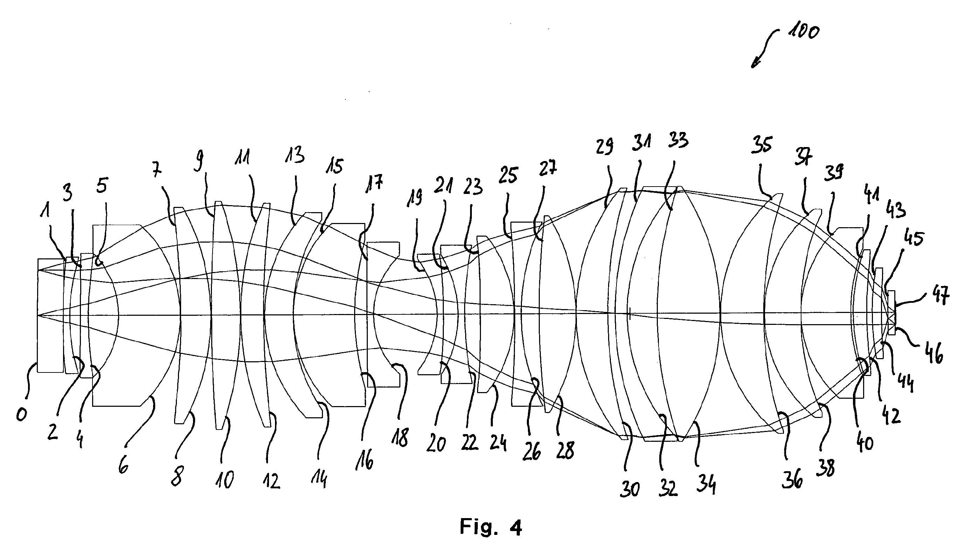

The projection-optical system according to the new design is illustrated in Figure 4, and the optical design data thereof are indicated in Tables 5 and 6 below.

**Table 5**

| Surface | Radius | Thickness | Material | Index | Semidiam. |
|---|---|---|---|---|---|
| 0 | object plane | 31.9999 | LUFTV193 | 1.000302 | 56.1 |
| 1 | 57573.3843 | 8.0000 | SIO2V | 1.560786 | 64.5 |
| 2 | 243.8108 | 13.2707 | N2VP950 | 1.000300 | 66.1 |
| 3 | -1090.1430 | 9.3540 | SIO2V | 1.560786 | 67.4 |
| 4 | 466.1455 | 37.5471 | N2VP950 | 1.000300 | 70.6 |
| 5 | -105.4891 | 75.0000 | SIO2V | 1.560786 | 72.2 |
| 6 | -148.9142 | 0.5855 | N2VP950 | 1.000300 | 107.4 |
| 7 | -934.5665 | 36.2435 | SIO2V | 1.560786 | 123.6 |
| 8 | -274.0353 | 0.6116 | N2VP950 | 1.000300 | 127.3 |
| 9 | 1877.0035 | 35.1457 | SIO2V | 1.560786 | 133.6 |
| 10 | -433.1584 | 0.6411 | N2VP950 | 1.000300 | 134.3 |
| 11 | 340.4737 | 28.3403 | SIO2V | 1.560786 | 131.8 |
| 12 | 1177.9580 | 0.9582 | N2VP950 | 1.000300 | 130.2 |
| 13 | 180.5848 | 34.5615 | SIO2V | 1.560786 | 121.2 |
| 14 | 206.7582 | 0.5010 | N2VP950 | 1.000300 | 112.1 |
| 15 | 155.9390 | 75.0000 | SIO2V | 1.560786 | 108.4 |
| 16 | 281.7713 | 15.0536 | N2VP950 | 1.000300 | 85.6 |
| 17 | 15953.6157 | 8.0000 | SIO2V | 1.560786 | 83.1 |
| 18 | 98.4316 | 77.0419 | N-2VP950 | 1.000300 | 68.5 |
| 19 | -111.3081 | 8.0193 | SIO2V | 1.560786 | 64.3 |
| 20 | -702.5092 | 18.0835 | N2VP950 | 1.000300 | 68.1 |
| 21 | -138.0765 | 8.3622 | SIO2V | 1.560786 | 68.7 |
| 22 | 416.9722 | 18.5234 | N2VP950 | 1.000300 | 79.1 |
| 23 | -11234.1701 | 41.8736 | SIO2V | 1.560786 | 85.1 |
| 24 | -150.8930 | 0.8082 | N2VP950 | 1.000300 | 91.3 |
| 25 | -1297.1009 | 8.0000 | SIO2V | 1.560786 | 99.8 |
| 26 | 253.3111 | 21.8807 | N2VP950 | 1.000300 | 107.7 |
| 27 | 1068.9167 | 45.0713 | SIO2V | 1.560786 | 111.7 |
| 28 | -236.4449 | 0.5000 | N2VP950 | 1.000300 | 115.8 |
| 29 | 244.4476 | 38.4473 | SIO2V | 1.560786 | 149.2 |
| 30 | 557.4597 | 8.6440 | N2VP950 | 1.000300 | 148.6 |
| 31 | 360.5437 | 15.0000 | SIO2V | 1.560786 | 151.0 |
| 32 | 221.8805 | 36.5144 | N2VP950 | 1.000300 | 147.9 |
| 33 | 488.3008 | 77.1255 | SIO2V | 1.560786 | 149.9 |
| 34 | -279.9149 | 0.5220 | N2VP950 | 1.000300 | 151.5 |
| 35 | 187.8756 | 53.2248 | SIO2V | 1.560786 | 142.9 |

(continued)

| Surface | Radius | Thickness | Material | Index | Semidiam. |
|---|---|---|---|---|---|
| 36 | 489.3066 | 0.9446 | N2VP950 | 1.000300 | 139.2 |
| 37 | 163.2750 | 44.1943 | SIO2V | 1.560786 | 123.3 |
| 38 | 325.3976 | 0.4997 | N2VP950 | 1.000300 | 116.2 |
| 39 | 140.8663 | 60.7172 | SIO2V | 1.560786 | 100.5 |
| 40 | 235.7238 | 2.9779 | N2VP950 | 1.000300 | 73.3 |
| 41 | 232.8150 | 16.6707 | SIO2V | 1.560786 | 71.4 |
| 42 | 582.7767 | 6.7517 | N2VP950 | 1.000300 | 64.0 |
| 43 | 375.4083 | 11.2935 | SIO2V | 1.560786 | 50.1 |
| 44 | 687.6552 | 8.0752 | N2VP950 | 1.000300 | 42.4 |
| 45 | 0.0000 | 8.4995 | SIO2V | 1.560786 | 21.4 |
| 46 | 0.0000 | 1.0000 | H2OV193 | 1.436677 | 14.9 |
| 47 | image plane | | | | 14.0 |

**Table 6**

| | Aspherical Surfaces | | | | |
|---|---|---|---|---|---|
| SRF | 1 | 3 | 7 | 16 | 20 |
| K | 0 | 0 | 0 | 0 | 0 |
| C1 | 2.187157E-07 | 2.909419E-08 | -1.506913E-09 | -3.774747E-08 | -1.136180E-09 |
| C2 | -2.487757E-11 | 1.261210E-11 | 2.120740E-13 | 1.140271E-12 | -3.091171E-12 |
| C3 | 1.853585E-15 | -1.055565E-15 | 5.182820E-18 | 2.928811E-17 | -5.711004E-16 |
| C4 | -1.617589E-19 | 3.623046E-20 | 2.163295E-23 | -5.477432E-21 | 2.509741E-20 |
| C5 | 1.923071E-24 | 8.424309E-24 | -5.163241E-27 | 1.585045E-25 | 2.710175E-24 |
| C6 | 5.473790E-29 | -4.162924E-28 | 3.339083E-32 | 7.346294E-30 | -2.322363E-28 |
| | | | | | |
| SRF | 23 | 30 | 36 | 38 | 40 |
| K | 0 | 0 | 0 | 0 | 0 |
| C1 | -6.268577E-08 | 4.627188E-09. | 6.674974E-10 | 1.843071E-09 | 1.319594E-08 |
| C2 | 3.193567E-12 | -5.266R14E-14 | 2.315644E-13 | 4.289011E-13 | 5.402084E-12 |
| C3 | -1.596579E-16 | 2.137046E-18 | -6.968850E-18 | 1.594513E-17 | -1.867305E-16 |
| C4 | 9.929517E-21 | -4.215001E-23 | 1.939934E-22 | -1.418581E-21 | -2.952249E-22 |
| C5 | -4.198491E-25 | 8.116919E-28 | 4.518881E-28 | 3.966239E-26 | 1.127199E-24 |
| C6 | 1.525257E-29 | -1.111782E-32 | -1.675385E-32 | -2.085351E-31 | -1.348324E-28 |

The projection-optical system according to the new design has a same numerical aperture NA = 0.95 as the projection-optical system of the previous design and a similar aberration level of wavefronts of about 4.7 m$\lambda$.

The above illustrated method allows to modify an existing design of a projection-optical system wherein a high re-use of components involved in manufacture of the projection-optical system according to the existing design is obtained.

The projection-optical systems shown in Figures 1 and 4 and characterized by tables 1, 2 and 5, 6, respectively, form instances of a pair of projection-optical systems according to one concept of the present invention. The two projection-optical systems of the pair are sufficiently similar to each other such that a substantial number of components are identically used in both projection-optical systems of the pair. And, the two projection-optical systems of the pair are significantly different from each other such that they may be used in different applications. One significant difference between the two projection-optical systems is that the system shown in Figure 4 and characterized in tables 5 and 6 is a liquid-immersion system whereas the system shown in Figure 1 and characterized in tables 1 and 2 is a system having a gaseous medium disposed in a space between the exposed wafer and the image-side front lens of the system.

All lenses of the projection-optical system shown in Figure 1 except the lens having surfaces 29 and 30 and the lens having surfaces 45 and 46 form a first group of lenses, and all lenses of the projection-optical system shown in Figure 4.except that lens having surfaces 29 and 30 and the lens having surfaces 45 and 46 form a second group of lenses, and each lens of the first group has a lens of the second group associated therewith such that the associated lenses of the first and second groups have substantially the identical surface parameters and substantially identical distances between the lens surfaces. Surface 30 is an aspherical surface in both projection-optical systems. The aspherical surface 30 of the system shown in Figure 1 may be tested with the interferometer apparatus shown in Figure 2, and the aspherical surface 30 of the projection-optical system shown in Figure 4 may be tested using the interferometer apparatus shown in Figure 5. The interferometer apparatus shown in Figure 2 has a third group of lenses comprising the lenses having lens surfaces 201, 202, 203, 204, 205, 206, 207, 208, 209 and 210, and the interferometer apparatus shown in Figure 5 has a fourth group of lenses comprising the lenses having the lens surfaces 201, 202, 203, 204, 205, 206, 207, 208, 209 and 210. Each lens of the third group has a lens of the fourth group associated therewith such that the associated lenses of the third and fourth groups have substantially identical surface parameters and substantially identical surface distances.

The aspherical surface 30 of both projection-optical systems are sufficiently similar to each other such that they may be tested with interferometer apparatuses having groups of substantially identical lenses. However, the aspherical surfaces of the two projection-optical systems are sufficiently different from each other such that distances between adjacent associated pairs of lenses of the third and fourth groups differ by more than 1 mm. In particular, in the illustrated example, as it is apparent from tables 3 and 4, all distances between corresponding adjacent lenses of groups 3 and 4 differ by more than 1 mm. In particular, the distance between surfaces 206 and 207 in the interferometer optics shown in the example of Figure 2 is about 109 mm, wherein the corresponding distance between surfaces 206 and 207 of the interferometer apparatus shown in the example of Figure 5 is 260 mm, such that the distance between the corresponding pairs of lenses differs by more than 50 mm, and in particular by more than 100 mm.

The difference between the aspherical surfaces 30 of both projection-optical systems is sufficiently high such that these aspherical surfaces may not be tested with a same interferometer optics. If the aspherical surface of the second projection-optical system was mounted at a measuring position of the interferometer apparatus used for testing the aspherical surface of the first projection-optical system, a sufficient measuring accuracy may not be achieved. In particular, a resulting interference pattern would show a large number of fringes, such as more than one hundred fringes, making it impossible to analyze the interference pattern with an accuracy sufficient to calculate the surface shape of the aspherical surface with a sufficient precision therefrom. Therefore, different interferometer apparatuses have to be used for testing the aspherical surface of the first projection-optical system and the corresponding aspherical surface of the second projection-optical system.

The difference between the two aspherical surfaces 30 may be characterized as follows: It is assumed that the surface shapes of the two aspherical surfaces may be aligned on a common axis of rotational symmetry of the aspherical surfaces such that the surfaces coincide on the common axis. A distance between surface points of the two surfaces measured in a direction of the axis of symmetry will then increase with increasing distance from the axis and may then further decrease or further increase depending on the difference between the two aspherical surfaces. The difference between the two aspherical surface shapes may be also represented by formula (1) above. Table 7 shows the surface parameters of the aspherical surfaces 30 of the projection-optical systems of Figures 1 and 4.

**Table 7**

|  | Surface 30 | |
|---|---|---|
|  | of Figure 1 | of Figure 4 |
| C1 | 4.593566E-09 | 4.627188E-09 |
| C2 | -5.053471E-14 | -5.266814E-14 |
| C3 | 2.101535E-18 | 2.137046E-18 |
| C4 | -3.600921E-23 | -4.215001E-23 |
| C5 | 5.121271E-28 | 8.116919E-28 |
| C6 | -6.698801E-33 | -1.111782E-32 |

The differences between the two aspherical surfaces 30 of the embodiments of Figures 1 and 4 are further illustrated in Table 8 below.

**Table 8**

| Height [mm] | Aspheric sag from Figure 1 [mm] | Aspheric sag from Figure 4 [mm] | Difference in sag [mm] | Difference of Surface Normals [mrad] | Number of Fringes in Interferogram |
|---|---|---|---|---|---|
| 0 | 0.000000 | 0.000000 | | | |
| 15 | 0.202835 | 0.202079 | -0.000756 | -0.050400 | -47.8 |
| 30 | 0.814541 | 0.811530 | -0.003011 | -0.150333 | -142.5 |
| 45 | 1.844546 | 1.837815 | -0.006731 | -0.248000 | -235.1 |
| 60 | 3.308074 | 3.296185 | -0.011889 | -0.343867 | -326.0 |
| 75 | 5.225714 | 5.207206 | -0.018508 | -0.441267 | -418.4 |
| 90 | 7.623335 | 7.596601 | -0.026734 | -0.548400 | -520.0 |
| 105 | 10.532646 | 10.495707 | -0.036939 | -0.680333 | -645.1 |
| 120 | 13.992566 | 13.942752 | -0.049814 | -0.858333 | -813.8 |
| 135 | 18.051233 | 17.984872 | -0.066361 | -1.103133 | -1046.0 |
| 150 | 22.767840 | 22.680065 | -0.087775 | -1.427600 | -1353.6 |

In Table 8, column 1 represents a radial distance or height from an axis of rotational symmetry of the surface in mm, and columns 2 and 3 indicate the sag in mm of the respective surface. The sag is the distance of surface points from a plane which is tangent to the respective surface at the axis of symmetry. The sag is measured in a direction parallel to the axis of symmetry. The fourth column indicates a difference of sags between the two respective surfaces at the heights indicated in column 1, and the fifth column indicates a difference in surface slopes of the surfaces wherein the differences in surface slopes are indicated as angular differences of surface normals in mrad at the respective heights.

If both surfaces were measured using the same interferometer optics, the differences of the surface normals would result in a substantial difference in the number of generated interference fringes. The sixth column in table 8 indicates a number of interference fringes resulting from a given difference of surface normals. For example, at the height of 135 mm, the difference of surface normals is 1.103133 mrad. In a hypothetical interferometric measurement using measuring light of a wavelength of 632.8 nm and where the surface of a total diameter of two times 150 mm is imaged on the detector and wherein such difference in surface normals (1.103133 mrad at 135 mm) exists across the whole imaged surface, a number of 1046 interference fringes would be imaged onto the detector. It is apparent that such high number of interference fringes could not be resolved to a high accuracy in practice. For practical purposes it is desired to generate a lower number of interference fringes in the interferogram, such as 100 or 200 fringes.

The above considerations clearly indicate that it is not possible to test the aspheric surfaces 30 of the embodiments of Figures 1 and 4 by using the same interferometer optics. However, a shown in the above illustration, it is possible to modify the interferometer optics which is suitable to test the aspherical surface 30 of the embodiment of Figure 1 such that the modified optics can be used to test also the aspherical surface 30 of the embodiment of Figure 4.

In the above illustrated embodiments of the present invention, the projection-optical systems of the pair of projection-optical systems are each of a type having only lenses as optical elements. It is, however, also conceived within the present invention to apply the method of designing a new projection-optical system to catadioptric projection-optical systems having at least one reflective mirror disposed as an optical element in a beam path between the object plane and the image plane. The aspherical surface to be tested with the two different interferometer apparatuses as illustrated above may be an aspherical surface provided on any of the optical elements, i.e. on any of the lenses or any of the mirrors of such projection-optical systems. Thus, an embodiment of the present invention also includes a pair of catadioptric projection-optical systems. One example of a catadioptric projection-optical system which may be subject to the improvements provided by the present invention is illustrated in US 6,636,350 B2. The entire contents of this document are incorporated herein by reference.

Summarized, embodiments of the present invention provide a method of manufacture of a projection-optical system involving generating a new design thereof starting from an existing previous design. Herein, a combined design is subject to optimization, wherein the combined design comprises the design of the projection-optical system and a design of an interferometer optics used for measuring an aspherical surface of a lens of the projection-optical system.

The present invention has been described by way of exemplary embodiments to which it is not limited. Variations and modifications will occur to those skilled in the art without departing from the scope of the present invention as recited in the appended claims and equivalents thereof.

**Claims**

1.   A method of manufacturing a projection optical system for imaging a patterning structure disposed in an object plane of the projection optical system into an image plane of the projection optical system using imaging light, wherein the projection optical system comprises a plurality of optical elements;
the method comprising manufacturing the projection optical system according to a design of the projection optical system;
the design of the projection optical system comprising a plurality of parameters, the plurality of parameters including a plurality of fixed parameters and a plurality of free parameters;
wherein at least one optical element of the projection optical system has an aspherical surface, and wherein at least one free parameter of the design of the projection optical system is a surface parameter of the aspherical surface;
wherein the manufacturing of the projection optical system comprises measuring a surface shape of the aspherical surface using an interferometer apparatus, determining differences between the measured surface shape of the aspherical surface and the aspherical shape represented by the design of the projection optical system, and processing the aspherical surface based on the determined differences;
wherein the interferometer apparatus comprises an interferometer optics having a configuration conforming with a design of the interferometer optics;
wherein the design of the interferometer optics comprises a plurality of parameters, the plurality of parameters including a plurality of fixed parameters and at least one free parameter;
wherein the at least one free parameter of the design of the interferometer optics represents a distance between a pair of adjacent lenses of the interferometer optics;
wherein the design of the projection optical system and the design of the interferometer optics are determined by an optimization of values of the free parameters of the design of the projection optical system and the at least one free parameter of the design of the interferometer optics, wherein the optimization is based on a merit function which is at least dependent on values of the fixed parameters of the projection optical system, on the values of the free parameters of the projection optical system, on values of the fixed parameters of the interferometer optics and on a value of the at least one free parameter of the interferometer optics.

2.   The method according to one of claims 1 or 3, wherein the parameters of the design of the projection optical system further comprise at least one of:

a refractive index of a medium disposed between a pair of adjacent optical elements of the projection optical system;
a surface shape parameter of at least one surface of at least one optical element of the projection optical system;
a distance between a surface of a first optical element of the projection optical system and a surface of a second optical element of the projection optical system which is different from the first optical element;
a refractive index of a material of at least one lens of the projection optical system;
a distance between a first surface and a second surface of at least one lens of the projection optical system;
a distance between the object plane of the projection optical system and a surface of an optical element of the projection optical system closest to the object plane;
a distance between the image plane of the projection optical system and a surface of an optical element of the projection optical system closest to the image plane;
a refractive index of a medium disposed between the object plane and a surface of an optical element of the projection optical system closest to the object plane; and
a refractive index of a medium disposed between the image plane and a surface of an optical element of the projection optical system closest to the image plane.

3.   The method according to claim 1, wherein the at least one optical element includes a mirror and wherein the at least one aspherical surface includes a mirror surface of the mirror.

4.   The method according to claim 1, wherein the at least one optical element includes a lens and wherein the at least one aspherical surface includes a lens surface of the lens.

5. The method according to claim 1, wherein a first projection optical system has a previous design, the first projection optical system having an optical element having an aspherical surface, wherein the aspherical surface may be tested to a sufficient accuracy using a first interferometer apparatus having a first interferometer optics having a previous design;

the method further comprising:

setting initial values of a first group of the parameters of the designs of the projection optical system and the interferometer optics to be substantially equal to values of corresponding parameters of the previous designs of the first projection optical system and of the first interferometer optics;

setting at least one initial value of a parameter of a second group of the parameters of the design of the projection optical system to be different from a value of a corresponding parameter of the previous design of the first projection optical system, wherein the at least one parameter of the second group of the parameters of the design of the projection optical system is a fixed parameter; and

performing the optimization using the initial values of the first and second groups of parameters of the design of the projection optical system as starting values to determine a next design of a second projection optical system and a next design of a second interferometer optics.

6. The method according to claim 5, wherein the at least one parameter of the second group of the parameters of the design of the projection optical system comprises:

a refractive index of a material of at least one lens of the projection optical system;

a refractive index of a medium disposed between a pair of adjacent optical elements of the projection optical system;

a refractive index of a medium disposed between the object plane and an object side front optical element of the projection optical system closest to the object plane; and

a refractive index of a medium disposed between the image plane and an image side front optical element of the projection optical system closest to the image plane.

7. The method according to claim 5, wherein all shape parameters of first and second surfaces and a distance between the first and second surfaces of at least one lens of the interferometer optics are fixed parameters of the design of the interferometer optics.

8. The method according to claim 5, wherein all shape parameters of first and second surfaces and a distance between the first and second surfaces of at least three lenses of the interferometer optics are fixed parameters of the design of the interferometer optics.

9. The method according to claim 5, wherein the interferometer optics has at least one lens disposed in a beam path between the measured aspherical surface and a beam splitter for splitting a beam path from a light source to the measured aspherical surface a beam path from the measured aspherical surface to a detector, and wherein all shape parameters of first and second surfaces and a distance between the first and second surfaces of all lenses of the interferometer optics disposed between the beam splitter and the measured aspherical surface are fixed parameters of the design of the interferometer optics.

10. The method according to claim 5, wherein the medium disposed between the image plane and the surface of the optical element of the second projection optical system according to the next design closest to the image plane is a liquid and wherein a medium disposed between an image plane and an the surface of the optical element of the first projection optical system according to the previous design closest to the image plane of the first projection optical system is a gas.

11. The method according to claim 5, wherein the material of the at least one lens of the second projection optical system according to the next design is CaF2 and wherein a medium of a corresponding lens of the first projection optical system according to the previous design is SiO2.

12. A pair of projection optical systems, wherein each projection optical system comprises a plurality of optical elements for imaging a patterning structure disposed in an object plane of the projection optical system into an image plane of the projection optical system using imaging light, the optical elements comprising a plurality of lenses, wherein each of the plurality of optical elements has at least one optical surface, and wherein at least one optical surface of at least one of the plurality of optical elements is an aspherical surface,

wherein a first projection optical system of the pair of projection optical systems has a first group of optical elements, wherein each lens of the first group of lenses of the first projection optical system is defined by surface parameters of first and second surfaces and a distance between the first and second surfaces;

wherein a second projection optical system of the pair of projection optical systems has a second group of lenses, wherein each lens of the second group has associated therewith a corresponding lens of the first group such that each pair of corresponding lenses of the first and second groups have substantially identical surface parameters of their first and second surfaces and substantially identical distances between their first and second surfaces;

wherein a surface shape of the aspherical surface of the first projection optical system may be tested by using an interferometer apparatus having a first interferometer optics and wherein a surface shape of the aspherical surface of the second projection optical system is different from the surface shape of the aspherical surface of the first projection optical system and may be tested by an interferometer apparatus having a second interferometer optics;

wherein the first interferometer optics has a third group of lenses, wherein each lens of the third group of lenses of the first interferometer optics is defined by surface parameters of first and second surfaces and a distance between the first and second surfaces of the lens;

wherein the second interferometer optics has a fourth group of lenses, wherein each lens of the fourth group has associated therewith a corresponding lens of the third group such that each pair of corresponding lenses of the third and fourth groups have substantially identical surface parameters of their first and second surfaces and substantially identical distances between their first and second surfaces;

wherein at least one distance between a pair of adjacent lenses of the third group of lenses differs from a distance between a corresponding pair of adjacent lenses of the fourth group of lenses by more than 0.1 mm, or wherein a distance between the aspherical surface of the first projection optical system and a lens of the first interferometer optics closest to the aspherical surface in a testing position thereof differs from a distance between the aspherical surface of the second projection optical system and a lens of the second interferometer optics closest to the aspherical surface in a testing position thereof by more than 0.1 mm.

13. The pair of projection optical systems according to claim 12, wherein the at least one distance between the pair of adjacent lenses of the third group of lenses differs from the distance between a corresponding pair of adjacent lenses of the fourth group of lenses by more than 1.0 mm.

14. The pair of projection optical systems according to claim 12, wherein the distance between the image plane of the first projection optical system and the surface of the optical element of the first projection optical system closest to the image plane differs from the distance between the image plane of the second projection optical system and the surface of the optical element of the second projection optical system closest to the image plane by more than 1.0 mm.

15. The pair of projection optical systems according to claim 12, wherein a number of the lenses of the first group of lenses of the first projection optical systems is greater than 0.5 times a total number of the lenses of the first projection optical system.

16. The pair of projection optical systems according to claim 12, wherein a number of the lenses of the first group of lenses of the first projection optical system is greater than 0.8 times a total number of the lenses of the first projection optical system.

17. The pair of projection optical systems according to claim 10, wherein the surface shape of the aspherical surface of the first projection optical system differs from the surface shape of the corresponding aspherical surface of the second projection optical system such that a gradient of a difference of the two aspherical surfaces, measured in a direction of a common axis of symmetry of the two aspherical surfaces, exceeds a value of 6 $\mu$m divided by an effective diameter of the optical surface.

18. The pair of projection optical systems according to claim 12, wherein a refractive index of a material of at least one lens of the first group differs from a refractive index of a material of the corresponding at least one lens of the second group by more than 0.03.

19. The pair of projection optical systems according to claim 12, wherein a material of at least one lens of the first group is $SiO_2$ and wherein a material of- the corresponding at least one lens of the second group is $CaF_2$.

20. The pair of projection optical systems according to claim 12, wherein a refractive index of a medium disposed between a pair of adjacent lenses of the first group differs from a refractive index of a medium disposed between a pair of corresponding adjacent lenses of the second group by more than 1*10e-4.

**21.** The pair of projection optical systems according to claim 12, wherein a refractive index of a medium disposed between the image plane and an image side front lens of the first projection optical system differs from a refractive index of a medium disposed between the image plane and an image side front lens of the second projection optical system by more than 0.3.

**22.** The pair of projection optical systems according to claim 12, wherein a medium disposed between the image plane and an image side front lens of the first projection optical system is a gas and wherein a medium disposed between the image plane and an image side front lens of the second projection optical system is a liquid.

**23.** The pair of projection optical systems according to claim 10, wherein a refractive index of a medium disposed between the object plane and an object side front lens of the first projection optical system differs from a refractive index of a medium disposed between the object plane and an object side front lens of the second projection optical system by more than $1*10e^{-4}$.

Fig. 1

**Fig. 2**

**Fig. 3**

Fig. 4

Fig. 5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2003077037 A1
- US 20040165159 A1

- US 6636350 B2

**Non-patent literature cited in the description**

- **DANIEL MALACARA.** Optical Shop Testing. John Wiley & Sons, Inc, 1992